(19) Europäisches Patentamt
European Patent Office
Office européen des brevets

(11) **EP 4 137 431 A1**

(12) **EUROPEAN PATENT APPLICATION**
published in accordance with Art. 153(4) EPC

(43) Date of publication:
**22.02.2023 Bulletin 2023/08**

(21) Application number: **20930880.8**

(22) Date of filing: **08.05.2020**

(51) International Patent Classification (IPC):
**B66B 1/46** (2006.01)  **H03K 17/955** (2006.01)

(52) Cooperative Patent Classification (CPC):
**B66B 1/46; H03K 17/955**

(86) International application number:
**PCT/CN2020/089182**

(87) International publication number:
**WO 2021/208156 (21.10.2021 Gazette 2021/42)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **13.04.2020  CN 202010287562
13.04.2020  CN 202020539977 U**

(71) Applicant: **Beijing Tashan Technology Co., Ltd.
Beijing 102300 (CN)**

(72) Inventors:
• **SUN, Tengchen
Beijing 102300 (CN)**
• **ZHANG, Dahua
Beijing 102300 (CN)**
• **ZHUANG, Wei
Beijing 102300 (CN)**

(74) Representative: **Plasseraud IP
66, rue de la Chaussée d'Antin
75440 Paris Cedex 09 (FR)**

(54) **HOVER BUTTON SENSOR UNIT AND METHOD FOR TRIGGERING HOVER BUTTON**

(57)    A hover button sensor unit, comprising: a power supply circuit (5-1), a capacitive sensor, a capacitance-to-digital conversion circuit (3), a control module, an acousto-optic feedback control circuit (5-3), and a communication circuit (5-2); The capacitive sensor is a convex structural arrangement of a central electrode (1-1) and a peripheral electrode (1-2). The capacitance-to-digital conversion circuit (3) measures self-capacitance and mutual capacitance of the central electrode (1-1) and the peripheral electrode (1-2) after human finger approaching, to calculate and determine whether a finger enters the area range and its dwell time, so that the control module outputs a control logic signal of the button; detecting the proximity of the human finger to the effective hover trigger area range above a certain central electrode (1-1) by means of the button formed by the sensor unit, providing three-state response to the human finger entering the effective hover trigger area range above a certain central electrode (1-1) by the acousto-optic feedback control circuit (5-3); The above mentioned technical scheme is reasonable in structural design, which can effectively resist various interference, fully utilize a low-cost of capacitance detection and mature CDC chip technology and provide a commercialized technical solution which can be popularized for hygienic sensitivity.

Figure 1

**Description**

**Technical field**

The present invention relates to buttons of public health, especially inductive buttons under consideration of hygienic sensitivity, such as faucets, flush buttons of toilets, waterproof buttons of water boilers, etc., especially the button design of elevators.

**Background technique**

The emergence of the novel coronavirus pneumonia epidemic, coupled with the situation of seasonal influenza, etc., the disinfection of elevators, especially the disinfection of button switches, faces a huge workload, and it is even difficult to achieve disinfection of viruses. For this reason, there is a social demand for proximity inductive button, because direct contact with button switches in public areas, such as elevator floor selection and door opening and closing buttons, toilet flush switches, public water dispenser switches, etc., are prone to infection of infectious diseases, and non-contact buttons can avoid such risk.

For the proximity of the human body, especially the proximity of the fingers operating the elevator buttons, there are many technical solutions that can be used, including technologies such as cameras, infra-red or radio-frequency, such as China Patent with No. 201480079328.5; however, capacitive induction is the lowest-cost solution among various induction solutions.

For the photoelectric induction faucets that are widely used in public areas and the human body induction control for flushing toilets, in addition to the high cost of the induction controller, there are still many problems that are difficult to control and do whatever you want. For example, when washing clothes and washing your face with a towel, the induction faucet is difficult to work properly, and users need an induction control technology that is very close to the control of a physical faucet.

Chinese patent 201480079328 discloses a technical solution for controlling an elevator by using gestures, in its specification, it mentions technologies like cameras to record gestures, including presetting gestures, its main technical composition is to record or even customize gestures first, the data of these gestures is recorded in the system to form a gesture library, and then after detecting a gesture command, it is compared with the gesture library to determine the meaning of the gesture, which is somewhat similar to the face recognition technology that has become popular; This technology requires many and expensive hardware devices, on the other hand, users' customization is also very difficult, due to the variety of human gestures and movements, this technology has considerable challenges in the two contradictions of accurately determining recognition and anti-interference, the absence of this product on the market also indirectly shows the difficulty of the technology.

The application No. 201610551225.5 proposes capacitive proximity button with groove, the capacitive proximity button is arranged at the bottom of the groove, by threshold design, the user's finger must be inserted into the groove to trigger the proximity button, the application does not disclose the specific capacitance measurement method of the capacitive proximity button, the solution has the defect that the user's finger sticks into the groove and easily touches the inner wall of the groove, especially in an environment such as an elevator where the lights are relatively dim and people may be crowded, at the same time, it is unlikely that the user of gesture induction can guarantee that the fingers of their movements can be completely controlled without shaking, otherwise the significance of hygienic sensitivity will be lost; on the other hand, the patent cannot avoid the impact of environmental factors such as temperature and humidity on the set thresholds.

**US** Patent US7498822 discloses a solution of capacitive induction of proximity of human finger, which also uses capacitive electrodes with a similar depressed design, the above problems also exist, if we try to avoid the above problems, according to our experiments, it is necessary to make the finger and the switch brim with a distance of more than 2cm as the design basis, in that way, the switch set to depressed electrodes needs to be designed with an inner diameter of at least 5cm, which makes the arrangement of many switch buttons of the elevator a challenge; in addition, the patent discloses a technical solution to measure the capacitance only by analog circuit, in addition, in order to eliminate mutual disturbances, the equipotential method and differential amplifiers etc. are deliberately used, however, after repeated experiments, the human finger relative to an electrode designed in the elevator environment at a safe distance to prevent unintentional touch, the change of the capacitance value generated is generally in the order of 10ff, it is difficult for analog circuit to achieve a good effect between measurement and elimination of environmental influences, and the cost of the required components is also high. In addition, the structure of the depressed electrode arrangement will increase the complexity of the structure molding of the hover button, which leads to an increase in processing costs, and affect the aesthetics of the hover button and the cleaning and disinfection of the elevator in the future. The US patent US7498822 only adopts the method of measuring self-capacitance, while rejecting the measuring method of mutual capacitance does not take advantage of the strong anti-interference ability of mutual capacitance to improve the performance of the hover button, in addition, this patent does not have the sound and light feedback system necessary for the hover button, it can cause confusion and inconvenience for the operator to use the hover button.

Capacitance-to-digital conversion circuits (CDC) of existing mature technologies, such as DAI7142 and ADI7147, adopt the method of Δ-Σ modulation to charge and discharge the measured capacitance for many times and comparing it with the reference capacitance (see: US Patent Number: 5,134,401) the measured capacitance value is directly converted into a digital counterpart, the measurement sensitivity of capacitance can be improved to 1ff level, which can easily meet the requirements of the measurement system for capacitance measurement sensitivity at a safe distance, especially, these chips are designed with multiple channels, which makes the circuit design simple and convenient, thereby effectively reducing the cost and installation difficulty.

Compared with the camera, infra-red or radio-frequency and other technologies, the capacitance detection technology has the characteristics of simple circuit structure and low cost etc. in detecting the proximity of the human body, but at the same time, there also exist small change in capacitance with high requirements for detection resolution, and capacitance detection extremely susceptible to environmental influences.

Generally speaking, the self-capacitance formed by the capacitive electrodes and the mutual capacitance formed between the electrodes will be affected by the approaching fingers, effectively using these affects to detect the proximity of the fingers while considering the different characteristics of the self-capacitance measurement and the mutual capacitance measurement, synchronously excluding the influence of other parts of the body, misoperation and environment on the measurement of electrode capacitance are not very easy at present.

For the hover button that adopts capacitive induction for human fingers approaching, it is necessary to fully consider the different inducting habits of users, and at the same time, to prevent false triggers caused by the induction of other parts of the body and the cleaning actions of cleaners, under such an environment in elevators, it is quite difficult to achieve accurate determinations, so no commercialized products have come out so far.

**Summary of the invention**

The purpose of the present invention is to overcome the deficiencies of the prior art, to create a capacitance sensor that is particularly suitable for the characteristics of the hover button, and cooperating with the mature capacitance-to-digital conversion technology, it makes full use of the specialties of CDC circuit in immunity to stray distributed capacitance, uses the combined measurement method of self-capacitance and mutual capacitance, coupled with three-state acousto-optic feedback circuit, considers the characteristics of human fingers approaching and avoids various interferences, to accurately determine the approaching action of fingers to trigger buttons, which is not only suitable for supporting of elevators, but also suitable for the transformation of existing elevator buttons, and it is also suitable for button controls of other hygienic sensitivity, the overall cost is easily accepted by commercialization.

The invention creates a capacitive sensor unit corresponding to one button, a hover button sensor unit, comprising: a power supply circuit, a capacitive sensor, a capacitance-to-digital conversion circuit, a control module, an acousto-optic feedback control circuit, and a communication circuit;

The capacitive sensor consists of one or more groups of electrodes, each group of electrodes comprises at least one central electrode, at least one peripheral electrode arranged around the central electrode, the height of the central electrode protruding from the peripheral electrode is 1.0-8.9mm;

The capacitance-to-digital conversion circuit comprises a capacitance excitation signal circuit, and the capacitance excitation signal circuit generates a high-frequency square wave excitation signal;

The above-mentioned central electrode and peripheral electrode are all connected to the capacitance-to-digital conversion circuit to detect self-capacitance and mutual capacitance of the group of central electrode and peripheral electrode after inducting the approaching of human fingers;

The capacitance-to-digital conversion circuit is connected with the control module, and the control module outputs trigger logic signal of the button according to the range of effective hover trigger area above the central electrode where the human finger points to and dwell time within this range.

The control module can use MCU, with the continuous development of electronic technology, there have been chips that combine the capacitance-to-digital conversion circuit CDC and the control module MCU, such as the PSoC 4100S Plus series of CYPRESS, but its functional composition remains the same.

At the same time, on the basis of the above sensor unit, the button triggering method of the present invention is detecting and calculating that the human finger enters the effective hover trigger area above a certain central electrode through the capacitive sensor, and providing pre-trigger response of the human finger entering the effective hover trigger area through the acousto-optic feedback control circuit;

If the human finger enters quick trigger area that is closer to the central electrode than the effective hover trigger area, the trigger logic signal of the button pointed by the human finger is directly output, and at the same time, the acousto-optic feedback control circuit responds to the triggered state; otherwise, it continuously detects whether the human finger stays in the effective hover trigger area or not, if it is and stays exceeding the set hover time, output the trigger signal of the button pointed by the human finger and at the same time the acousto-optic feedback control circuit responds to the triggered state; if it is detected that the finger has left the effective hover trigger area within the set hover time, the non-trigger state is returned.

In particular, the electrode arrangement of the present invention has the following advantages: first, the risk of fingers touching the side wall is fundamentally avoided; second, there is no need to consider the safety distance of the side wall, thereby effectively reducing the diameter of the hover button, the outer diameter of the entire button can be controlled below 3CM, which can easily meet the spatial layout requirements of multi-row buttons; third, the universal block design is convenient for mass production; fourth, because there is no need to insert fingers into the concave container, the surface of the hover button with convex-structure of multi-row can be uniformly decorated with flat decorative materials, such as glass, acrylic or other non-conductive materials, and the convex-structure itself can be realized with one or two layers of PCB boards at low cost.

**Description of drawings**

Figure 1 is a schematic diagram of the use state of the invention, and also shows the approaching state of the finger relative to the button, the solid line and the dotted line in the figure respectively shows different angle states of a human finger pointing to the button.

Figure 2 is a perspective view of the sensor of the present invention, including Figure 2-1 is a schematic diagram of a human finger approaching the capacitive electrode in a horizontal direction; Figure 2-2 is a schematic diagram of a human finger approaching the capacitive electrode in a 45° direction; Figure 2-3 is a schematic diagram of a human finger approaching the capacitive electrode in a vertical direction; Figure 2-4 is a schematic diagram of the entire human palm approaching the capacitive electrode.

Figure 3, including Figure 3-1 and Figure 3-2, is the positional relationship between finger and palm of the human body and the capacitive electrodes during operation of the present invention and the equivalent principle diagram of the capacitance embodied, wherein compared with Figure 3-1, Figure 3-2 shows the schematic diagram of the inducting range more clearly.

Figure 4 is a structural diagram of a capacitive sensor under a single capacitive electrode unit of present invention, wherein Figure 4-1 shows the mutual relationship of several capacitive electrodes in a top view, and Figures 4-2 and 4-3 show the schematic diagram of arrangement of the capacitive electrodes in cross-section view.

Figure 5 is a schematic diagram of electrode arrangement involving more than one group of electrode units of the present invention.

Figure 6 is a schematic diagram of the timing arrangement of the detecting capacitance of the present invention.

Figure 7 is a schematic diagram of the structural arrangement of the combination of capacitive electrode design and other circuits that is similar to Figure 4-2 with a single button;

Figure 8 is an exploded schematic diagram expressing the structural arrangement of an elevator up and down buttons/double buttons basic unit applying the present invention.

Figure 9 is a principle diagram of the capacitance electrode measurement and control etc. of the present invention.

Figure 10 is a schematic diagram of the circuit structure of the multi-row button arrangement in the elevator.

Figure 11 including Figure 11-1, Figure 11-2, Figure 11-3, Figure 11-4, Figure 11-5, Figure 11-6, which are schematic diagrams of various structural forms of the central electrode and the peripheral electrode, respectively.

Figure 12 is a system flowchart of determining whether a finger is approaching or not of the present invention.

Figure 13, including Figure 13-1, which is a schematic diagram that reflects the effect of the finger on the self-capacitance of the electrode, and Figure 13-2, which shows the equivalent circuit at this time.

Figure 14, including Figure 14-1, which is a schematic diagram that reflects the effect of the finger on the mutual capacitance between the two electrodes, and Figure 14-2, which shows the equivalent circuit at this time.

**Detailed description**

The present invention applies to the buttons inducting the control of finger approaching in occasions of hygienic sensitivity, the elevator buttons are mainly introduced in detail below, the technologies achieved through these introductions are also applicable to button controls in other hygienic-sensitivity.

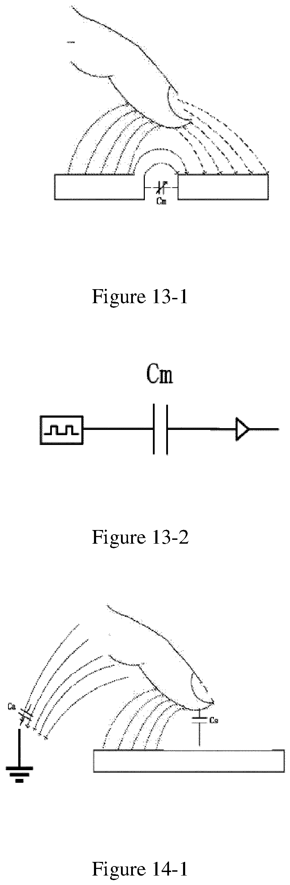

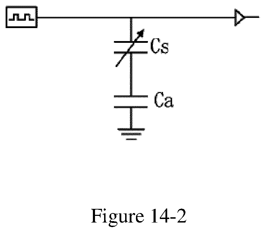

For the situation using capacitance measurement to calculate and determine the proximity of the finger to the electrode, it is necessary to explain the self-capacitance and mutual capacitance of the electrodes, combined with Figure 13 and Figure 14; the principle of capacitance detecting human proximity can be divided into two ways of self-capacitance detection and mutual capacitance detection, see Figure 13-1 for the detection principle of mutual capacitance, when the human body approaches, the electric field lines of the mutual capacitance Cm formed between the two electrodes are disturbed by the human body, causing the change of capacitance value of the mutual capacitance Cm, which is proportional to the average distance of the human body approaching to the two electrodes, apply an excitation signal to one of the electrodes and connect the measurement circuit to the other electrode to detect the change of value in mutual capacitance, its equivalent measurement circuit is shown in Figure 13-2, generally, the measurement distance of the mutual capacitance is small, but the anti-interference ability is strong; see Figure 14-1 for the detection principle of self-capacitance, when the human body approaches a single electrode, a self-capacitance Cs will be formed between the single electrode and the human body, and the self-capacitance Cs will be grounded to the equivalent capacitance Ca of the earth by passing through the human body, and Cs is proportional to the distance of the human body approaching to the single electrode, the equivalent capacitance Ca of the human body to the earth is about 200PF, while the changing range of the self-capacitance Cs is usually less than 1PF, Figure 14-2 is the equivalent circuit of measuring self-capacitance, it can be seen that Ca and Cs are in series relationship, according to the series capacitance formula, the equivalent capacitance of series capacitance $Cx=Ca*Cs/(Ca+Cs)$, because Ca is much larger than Cf, so the numerator $Ca+Cs≈Ca$, and then there is $Cx≈Ca*Cs/Ca=Cs$, that is, the mutual capacitance Cs can be approximated as the capacitance of the single electrode to the earth, so measuring the self-capacitance is equivalent to measuring the capacitance of a single electrode to the earth, the mutual capacitance is proportional to the distance of the human body from a single electrode; unlike the mutual capacitance that the excitation signal and the measurement circuit are connected to two electrodes respectively, the excitation signal and the measurement circuit of the self-capacitance are connected to the same electrode, and the measurement distance of the self-capacitance is generally far, but the anti-interference ability is weak; on the contrary, the measurement distance of the mutual capacitance is relatively less affected by the electrode arrangement, but its anti-interference ability is strong.

For elevator buttons, there are three cases, one is the case of one button, two is the case of two up and down buttons, and three is the case of multiple buttons in the elevator car;

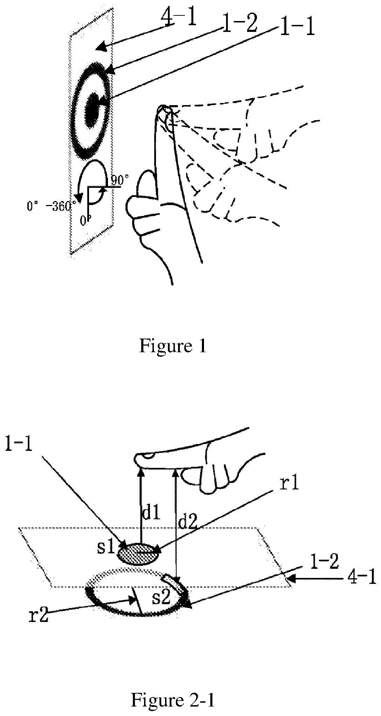

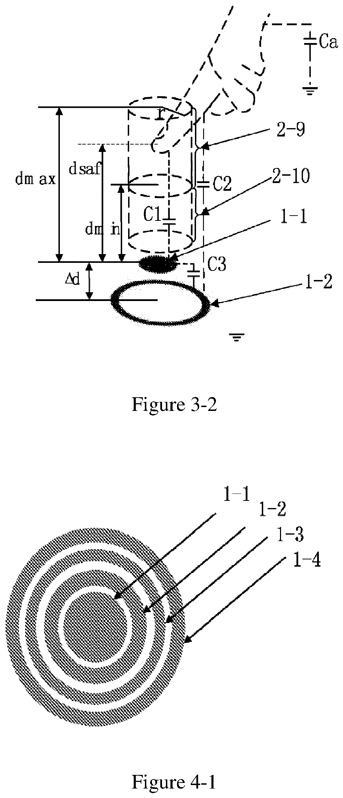

For elevator users, it is possible to use a finger to trigger a button from different angles of up, down, left, and right, in the application scenario of a contact button switch, parallel to the direction of the button, within a 360-degree range, human fingers should trigger the switch no matter from any direction angle contacting the button, while in the direction perpendicular to the button, finger contacting the button at any angle from 0 to 90 degrees should trigger the switch, likewise the hover button should also satisfy the requirements that the switch can be effectively triggered within the same directions and angular range with the contact button. Figure 1 shows three states of the human finger approaching the button electrode, including the parallel entry shown by the solid line, the 45° angle entry and the vertical 90° angle entry shown by the dotted lines, in Figure 4-1 is the button panel, 1-1 is the central electrode, and 1-2 is the peripheral electrode. The invention is to make the three kinds of approaching methods of fingers can be responded to.

The hover button needs to effectively prevent false triggering caused by the large area of the human body approaching the hover button, including various false triggering situation such as when there are many people in the elevator, the arm or back is close to or appressed to the hover button, and when cleaning the palm or fist is close to the hover button. In order to make full use of the pointing action of stretching out a finger from the human palm, it is necessary to design the capacitive electrodes with considerable redundancy to distinguish them.

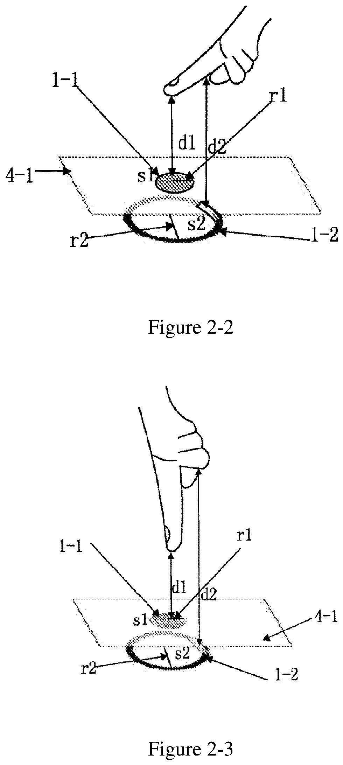

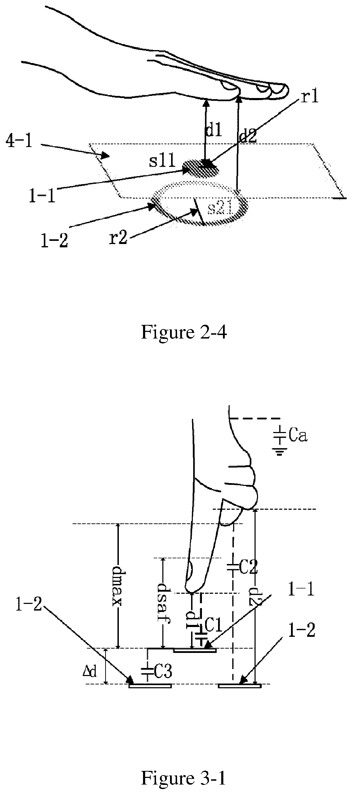

Figure 2 shows a schematic diagram of three states of human fingers to trigger the button and a schematic diagram of the palm approaching the button, the present invention requires that the method for triggering the hover button is: stretching out with the index finger, and making a fist with the remaining 4 fingers; this action is also normal pointing action of human fingers; as shown in Figure 1, in the direction perpendicular to the hover button, it can approach the central electrode at any angle in the range of 0 to 90 degrees, and in the direction parallel to the hover button, it can approach the central electrode at any angle in the range of 360 degrees. Figures 2-1, 2-2 and 2-3 show the cases where the finger approaches the hover button in the direction perpendicular to the hover button at angles of 0 degrees (horizontal), 45 degrees and 90 degrees, respectively, wherein the projected area s1 of finger to central electrode remains basically unchanged in the range of 0 to 90 degrees, while the projection s2 of finger to peripheral electrode remains basically unchanged in the range of 0 to 45 degrees, which is about $1/2\pi r2$ of the peripheral electrode area s21, wherein r2 is the radius of the peripheral electrode. Due to the influence of the remaining 4 fingers of the fist, the projected area s2 gradually increases in the range of 45 degrees to 90 degrees, and reaches a maximum value at an angle of 90 degrees, which is about 1/4 of the peripheral electrode area s21. On the premise that the distance d1 between the finger tip and the central electrode remains unchanged at the minimum safe distance (2CM), the distance d2 from the finger to the peripheral electrode varies with the vertical angle from 0 degrees to 90 degrees between the finger and the hover button, from the minimum $d2=d1+\Delta d$ to the maximum $d2= d1+finger$ length range. Figure 2-4 shows the situation that a large area part of the human body represented by the palm is close to the hover button, since the palm can completely cover the hover button, the projected area of the palm to the central electrode is equal to the area s11of the central electrode itself, and the projected area of the palm to the peripheral electrode is equal to the area s21 of the peripheral electrode itself, under the condition that the distance d1 from the palm to the central electrode also remains at the minimum safe distance, the distance from the palm to the peripheral electrode is $d2=d1+\Delta d$. In the embodiment of the present invention, the radius r1 of the central electrode is selected to be 1.25CM, the inner ring radius of the peripheral electrode is 1.25CM, the outer ring radius r2 is 1.75CM, and the height difference $\Delta d$ between the central electrode and the peripheral electrode of the convex electrode structure is 0.5CM, as shown in the following table, the theoretical calculation values of C1/C2 when a finger with a diameter of about 1CM approaches the hover button from different angles and the palm approaches the hover button:

| Proportion calculation table of C1/C2 (the length unit is cm, the area unit is $cm^2$) | | | | | | | | | | |
|---|---|---|---|---|---|---|---|---|---|---|
| | r1 | r2 | s1 | s2 | s1/s2 | d1 | $\Delta d$ | d2 | d1/d2 | C 1/C2 |
| Horizontal palm | 1.25 | 1.75 | 4.91 | 4.71 | 1.04 | 2.00 | 0.50 | 2.50 | 1.25 | 1.30 |
| Horizontal finger | 1.25 | 1.75 | 2.45 | 0.43 | 5.72 | 2.00 | 0.50 | 2.50 | 1.25 | 7.15 |
| Finger in 45 degrees | 1.25 | 1.75 | 2.45 | 0.43 | 5.72 | 2.00 | 0.50 | 4.25 | 2.13 | 12.16 |
| Finger in 90 degrees | 1.25 | 1.75 | 2.45 | 1.18 | 2.08 | 2.00 | 0.50 | 8.50 | 4.25 | 8.85 |

It can be seen from the table that C1/C2 = 1.3 for the horizontal palm, and C1/C2 >= 7.15 for the fingers of each angle, indicating that the large area part of the body represented by the palm is significantly different from the small area of the fingers, we select the threshold of C1/C2 as 3*1.30=3.9 according to 3 times amount of the redundancy, which can distinguish the proximity of fingers and palms very reliably, a lot of experimental data carried out in our company laboratory also proves the above conclusion..

Time-sharing measurement

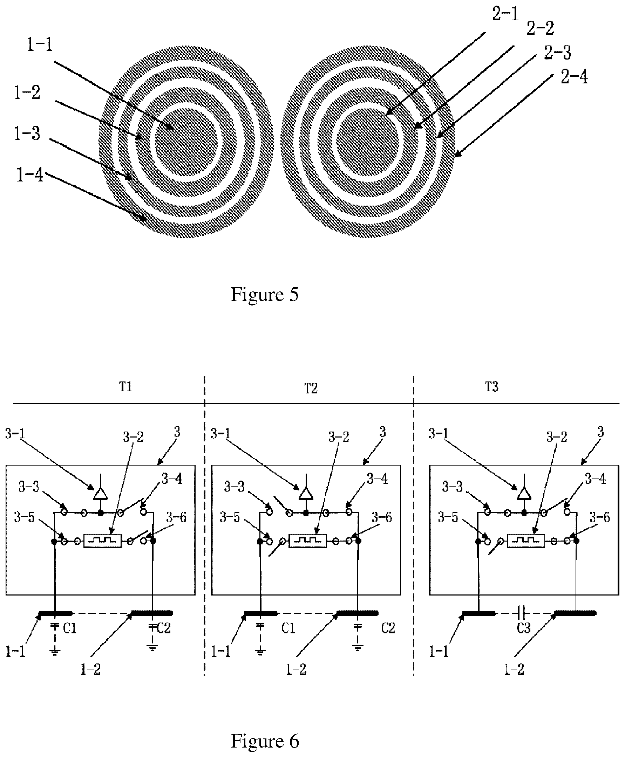

As shown in Figure 6, the present invention uses the analog switches in the capacitance-to-digital conversion circuit CDC to periodically time-sharing to detect the self-capacitance C1 formed by the central electrode 1-1 and the human body, and the self-capacitance C2 formed by the peripheral electrode 1-2 and the human body as well as the mutual capacitance C3 formed by the central electrode 1-1 and the peripheral electrode 1-2, one measurement period T is divided into three time segments T1, T2 and T3. As shown in Figure 6, in the T1 time period, the analog switches 3-3 and 3-5 are closed, and the analog switches 3-4 and 3-6 are shut off, at this time, the square wave excitation signal is applied to the central electrode 1-1, and the capacitance measurement signal is also taken out from the central electrode 1-1; in the T2 time period, the analog switches 3-3 and 3-5 are shut off, and the analog switches 3-4 and 3-6 are closed, at this time, the square wave excitation signal is applied to the peripheral electrode 1-2, and the capacitance measurement signal is also taken out from the central peripheral electrode 1-2; in the T3 time period, the analog switches 3-3 and 3-6 are closed, and the analog switches 3-4 and 3-5 are shut off. At this time, the square wave excitation signal is applied to the peripheral electrodes 1-2, and the capacitance measurement signal is taken out from the central electrode. Using the above time-sharing measurement method, on the one hand, the capacitance detection sensitivity can be increased to ff level to meet the requirements of the minimum safe distance, and on the other hand, it is not necessary to keep equipotential of the central electrode and the peripheral electrode to eliminate the influence of C3 as is proposed in patent No.: US 7,498,822 B2, on the contrary, the time-sharing measurement of C3, which is not affected by C1 and C2, can make the hover button retain the function of contact quick triggering.

Effective hover trigger area

As shown in Figure 3-2, the present invention uses the measurement of capacitance values of C1, C2 and C3 to set by calculation the effective hover trigger area 2-9 of the hover button in present invention represented by the dotted cylinder above the central electrode 1-1, when the finger enters the area and the hover time in the area exceeds the specified hover time threshold (for example, 1 second), the hover button is triggered.

In this embodiment, the distance dmin from the bottom surface of the effective hover trigger area to the central electrode 1-1 is set to 0.5CM, once the distance between the finger and the central electrode is less than 0.5CM, no hover time is required, and the hover button can be triggered immediately. The distance dmax from the top surface of the effective hover trigger area to the central electrode is set to 4CM, and the minimum safe distance dsaf from the finger to the hover button is set to 2CM, which can ensure that there is a vertical jitter interval of 2CM above the minimum safe distance, it can improve reliability of trigger, the radius r of the effective hover trigger area is approximately equal to the radius r1 of the central electrode. As shown in Figure 3-1. Under the condition that $\Delta d$ is definite, the above-mentioned vertical distances dmax, dsaf and dmin all have a monotonic function relationship with the capacitance ratio C1/C2, which can be determined by calculating the value of C1/C2, the larger the $\Delta d$ is, the higher the vertical distance resolution is, but if the $\Delta d$ is too large, it will significantly reduce the sensitivity of the hover button, so it should generally be selected between 0.1CM and 1CM, through repeated experiments, it is found that the distance1.0-8.9MM between the two electrodes (height difference) is more appropriate, which has taken into account the sensitivity of the measurement, the electrode design and the applicability to the majority of users, in this embodiment, $\Delta d=0.5CM$ is preferred. Figure 2, Figure 3-1 and Figure 3-2 show the setting and calculating principle of the effective hover trigger area, wherein $\Delta d$ is the height difference between the central electrode 1-1 and the peripheral electrode 1-2 of the convex structure, and d1 is the distance from the central electrode to the finger, d2 is the distance from the peripheral electrode to the finger, s1 is the projected area of the finger on the central electrode, and s2 is the projected area of the finger on the peripheral electrode, it can be obtained from the basic formula of capacitance

$$|C1/C2=\varepsilon 1*s1*d2/\varepsilon 2*s2*d1=\varepsilon 1*s1*(d1+\Delta d)/\varepsilon 2*s2*d1,\text{---}(1)$$

Wherein, $\varepsilon 1$ and $\varepsilon 2$ are the dielectric constants of capacitances C1 and C2, respectively, under the same measurement environment, $\varepsilon 1=\varepsilon 2$, thus after fraction reduction, the formula (1) becomes:

$$C1/C2=S1*(d1+\Delta d)/\ S2*d1\text{---}(2)$$

The formula (2) shows that C1/C2 has nothing to do with the dielectric constant. After sorting formula (2), we can get:

$$D1=\Delta d/((s2/s1)*(C1/C2)-1)\text{---}(3)$$

Since the projected areas s1 and s2 of the finger changing from 0 to 90 degrees in the direction perpendicular to the central electrode 1-1 are basically unchanged, that is, s2/s1 is a constant, thus formula (3) shows that the distance of the finger proximity has a one-to-one inverse relationship with the ratio C1/C2 of the two capacitances, that is, the distance d1 of the finger proximity can be calculated by using C1/C2, thus, as shown in Figure 3-2, the largest height dmax, the minimum height dmin and the minimum safe distance dsaf of the effective hover trigger area 2-9 which approximates cylinder can all be set by the corresponding ratio of C1/C2, and the radius r of the effective hover trigger area 2-9 can use the capacitance value of the mutual capacitance C3 between the center electrode 1-1 and the peripheral electrode 1-2 to define it within a range approximately equal to the radius r1 of the central electrode 1-1. Note that there is no influence of the dielectric constant $\varepsilon$ in the formula (3), thus the influence of the temperature, humidity and different media of the measurement environment on the distance measurement accuracy has been eliminated.

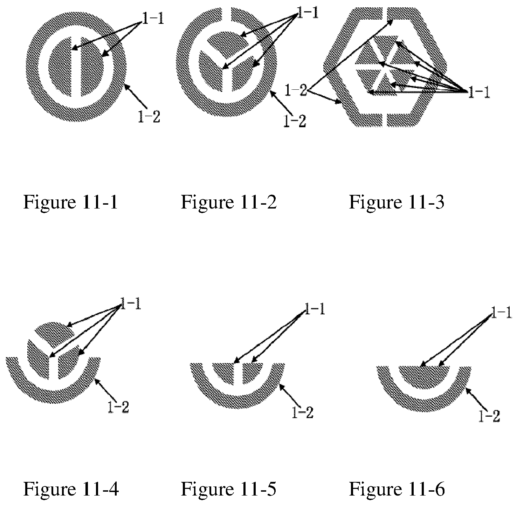

For the various central electrodes shown in Figure 11, the effective hover trigger area above the central electrode is a cylinder whose cross-sectional shape is the projection of the periphery of the central electrode, and the bottom of which is the distance dmin away from the central electrode, dmax is the distance from its top to the central electrode, the above dmin is 0.5CM, the dmax is 4CM. For dmin, the main consideration is that the mutual capacitance detection determination is very accurate, and it is less affected by the environment, and setting this value is for the consideration that determining whether the user wants to trigger quickly or not, while for the setting of dmax, it not only effectively balances the resolution and accuracy of the measurement, but also balances the problems caused by the necessary shaking of the user's finger during the hover trigger process.

Hover time

In application of multiple hover buttons, when the finger searches for the effective hover trigger area of the target hover button, it may pass the effective hover trigger area of the adjacently arranged hover buttons, resulting in false trigger of adjacent hover buttons; To avoid false trigger of adjacent hover buttons, the present invention adopts the method of specifying the hover time of the finger in the effective hover trigger area of the hover button, so as to avoid false trigger of passing the button. According to different application scenarios, the hover time can be specified between 0.3s and 5s, in principle, the longer the hover time is, the better the anti-false trigger effect will be, however, if the hover time is too long, the trigger response time will be prolonged, and the user's operating experience will be affected, the elevator suspension button of the embodiment of present invention specifies that the suspension time is 0.5s-1s.

Quick trigger area

As mentioned above, the hover button needs to have a hover time (for example, 0.5s-1s), in order to meet the diverse needs of people, and the quick trigger requirements of the hover button in emergency situations, the hover button must retain the function of contact quick trigger, that is, when the finger touches the surface of the hover button, it can trigger the button switch immediately without waiting for the hover time to expire, see Figure 3-2, when the human finger is closer to the central electrode than the above-mentioned effective hover trigger area range, that is, when the distance between the finger and the central electrode is less than dmin, it will enter the quick trigger area 2-10, at this time, there is no need to wait for the hover time to expire, and the hover button will be triggered immediately.

Active shielding

Referring to a single electrode unit in Figure 4-1 and a schematic diagram of two adjacent electrode units in Figure 5, in order to suppress the interference and crosstalk between adjacent electrode units or the environment to the central electrode 1-1 and the peripheral electrode 1-2, an anti-crosstalk electrode 1-4 is set, but the setting of the anti-crosstalk electrode 1-4 will bring about the problem that the measurement sensitivity of the central electrode 1-1 and the peripheral electrode 1-2 will decrease, in order to improve its measurement sensitivity, the active shielding electrodes 1-3 are arranged between the peripheral electrode 1-2 and the anti-crosstalk electrodes 1-4, and the active shielding electrodes 1-3 rely on the mature technology in the capacitance-to-digital conversion circuit CDC, that is, rely on the operational amplifier in the CDC to form a voltage follower connected with the central electrode or the peripheral electrode, to keep the active shielding electrode 1-3 between the central electrode 1-1 or the peripheral electrode 1-2 and the large-area metal ground or the earth electrode 1-4 at equipotential, thereby avoiding or reducing the loss of electric field energy of the measuring electrode bypassing to the ground, to improve the measurement sensitivity of capacitances C1 and C2, so as to meet the requirements of the minimum safe distance.

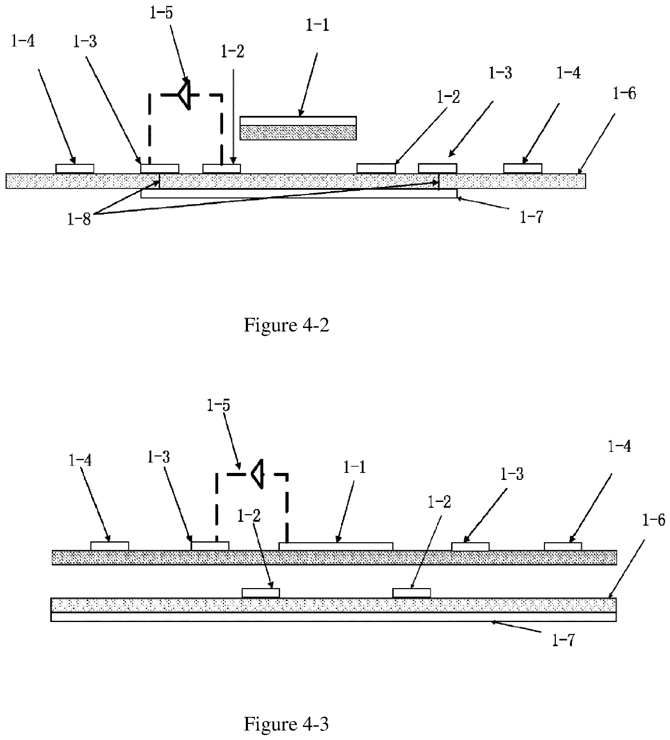

Further, in many application scenarios of hover button, there is usually a large area of metal being grounded below the hover button, for example, the cabinet of elevator car is generally made of metal, for safety, the cabinet of elevator car needs to be grounded, in terms of self-capacitances C1 and C2 of the hover button, the large area of grounded metal will greatly reduce the measurement sensitivity of C1 and C2, so that the hover button cannot meet the requirements of minimum safe distance, as shown in Figure 4-2, another active shielding electrode 1-7 is arranged in the present invention below the peripheral electrode 1-2 of the convex structure, in the embodiment of Figure 4-2, relying on vias 1-8 of PCB board to connect (the active shielding electrode 1-3 and 1-7), the experiments show that, the crosstalk between adjacent external electrodes and the influence of large area of grounded metal can be reduced to an acceptable level by using the above structure.

Acousto-optic feedback

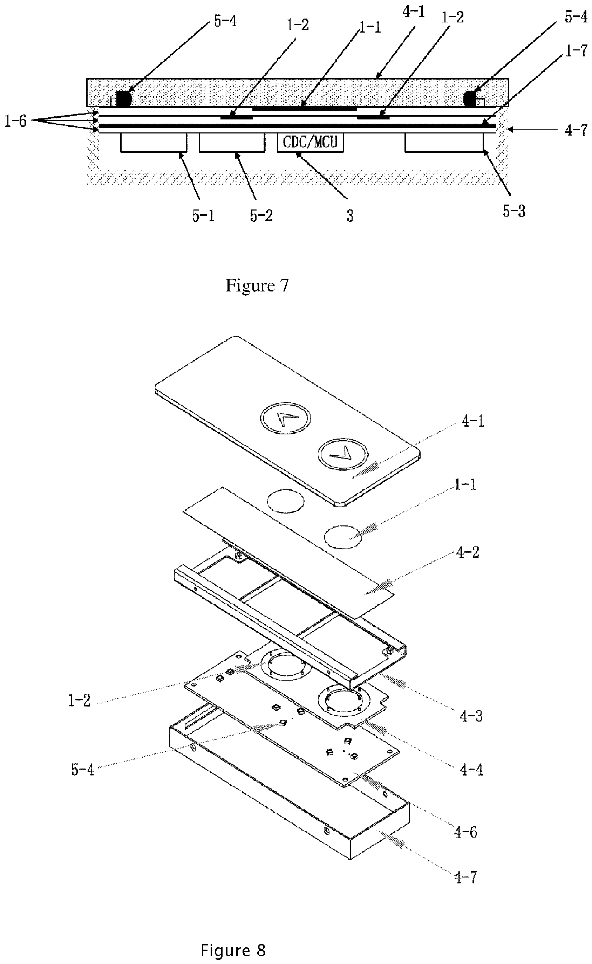

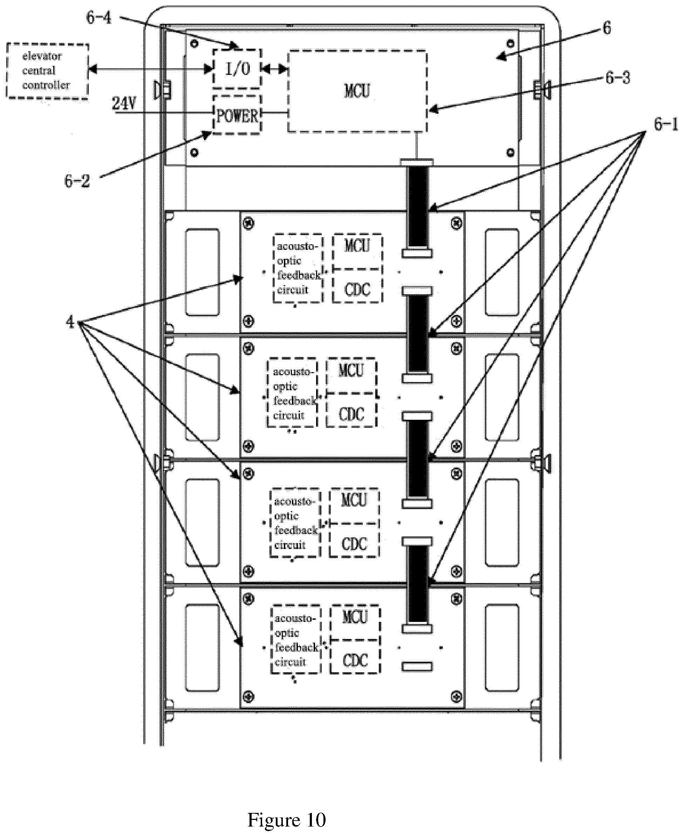

The contact button can usually provide the operator with tactual feedback of two states through the displacement action of the mechanical switch or the acousto-optic feedback circuit, that is, the trigger state and the non-trigger state, so that the operator can confirm that the button switch has been successfully triggered and can let the hand leave the button. See Figures 8, 9 and 10, the hover button of the present invention also includes an acousto-optic feedback control circuit 5-3 and a multi-color LED indicator 5-4, which is different from the tactual feedback of the two states of the above-mentioned contact button, in order to avoid false trigger caused by the finger passing the effective hover trigger area, the finger needs to hover in the effective hover trigger area for a specified time, and the hover button needs at least 3 states of non-contact tactual feedback (implemented by means of light or sound). The first state is the non-trigger state, which means that the finger has not entered the effective hover trigger area, it can be indicated by light off or silent; The second state is the pre-trigger state, which means that the finger has entered the effective trigger range, which can be indicated by a single-color light flashing or lighting up a specific color (eg: yellow) of the multi-color light, or using a certain sound, to remind the operator that it has entered the effective hover trigger area of the hover button; And the third state is the triggered state, indicating that the finger has hovered for specified hover time in the effective trigger area, and the hover button is triggered, which can be indicated by the single-color indicator changing from flashing to steady lighting on or the multi-color indicator changing to another color, or using another sound.

Functional block diagram description

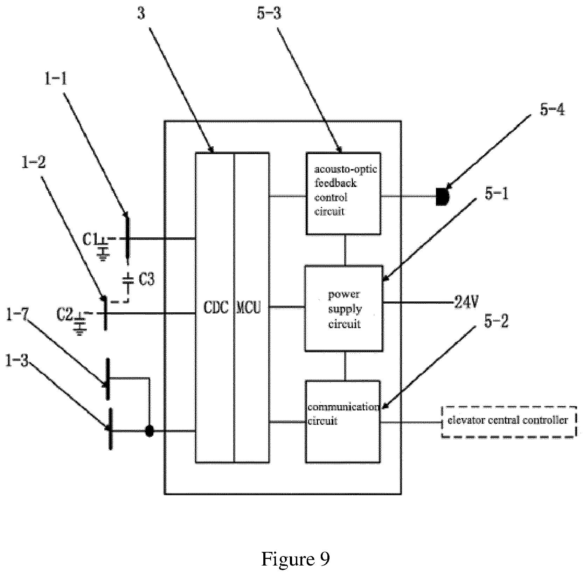

Referring to Figure 9, the central electrode 1-1, the peripheral electrodes 1-2 and the active shielding electrodes 1-3 and 1-7 are all connected to the CDC, and the CDC periodically time-sharing to measure the self-capacitance C1 formed between the central electrode 1-1 and the human body, the self-capacitance C2 formed between the peripheral electrodes and the human body and the mutual capacitance C3 formed between the central electrode 1-1 and the peripheral electrode 1-2, in order to improve the sensitivity of C1 or C2, the operational amplifier in the CDC is used to form the voltage follower, which makes the electrodes 1-3, 1-7 and 1-2 form an equipotential to achieve the effect of active shielding (refer to Figures 4-2 and 4-3). The CDC inputs the measured capacitance values of C1, C2 and C3 to the MCU, and the MCU calculates the value of C1/C2 and determines whether the finger enters or leaves the effective hover trigger area 2- 9 by calculation according to the values of C1/C2 and C3, according to the determination result, three-state acousto-optic feedback is provided through the acousto-optic feedback control circuit, and at the same time, the trigger logic signal of the hover button is sent to the elevator central controller through the communication circuit.

Electrode arrangement form

In order to meet the consistency requirements of triggering the switch in different directions with the finger parallel to the hover button, the central electrode is preferably circular, and the outer electrode is preferably circular, of course, polygons can also be used, the central electrodes can be arranged with multiple electrodes, the mutual capacitance between the multiple electrodes further improves the reliability of the quick trigger area, and the peripheral electrodes can also be arranged with multiple electrodes, which is beneficial to more accurately determine the radius of the effective trigger area that is approximately a cylinder. Figures 11-1, 11-2 and 11-3, Figures 11-4, 11-5, and 11-6 respectively show the schematic diagrams of the arrangement form of 2 pieces of central electrodes, the arrangement form of 3 pieces of central electrodes, and the arrangement form of 6 pieces of central electrodes and 2 pieces of peripheral electrodes, 3 pieces of central electrodes and 1 pieces of peripheral electrodes in non-closed loop, 2 pieces of central electrodes and peripheral electrodes in non-closed loop, 1 piece of central electrodes and peripheral electrodes in non-closed loop. That is, the central electrode may be composed of multiple petals, and the peripheral electrode may be composed of a closed-loop or open-loop of circular ring, or a semi-circular ring. In addition, the anti-crosstalk grounded annular electrode 1-4 and the active shielding electrode 1-3 can also be arranged on the same level as the central electrode, as shown in Figure 4-3.

Operation method

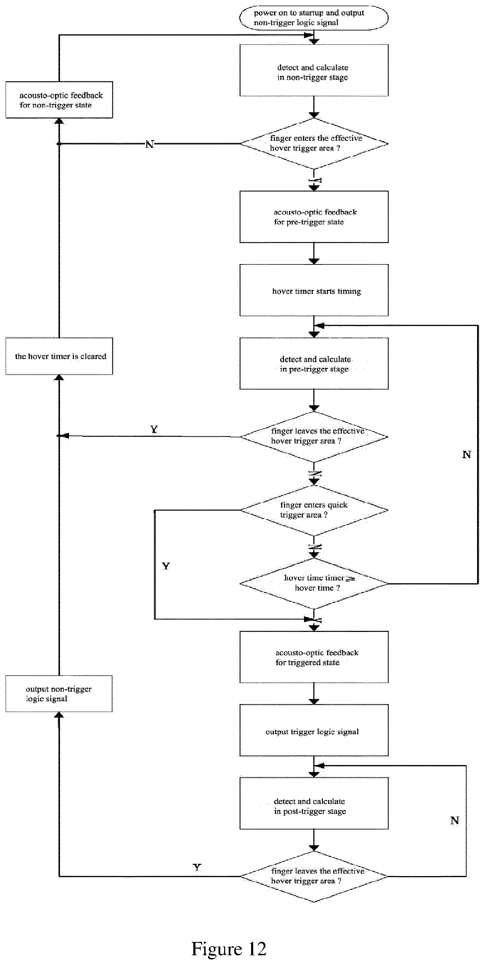

The hover button operation method of the present invention is shown in Figure 12, when the hover button is powered on, it first outputs a non-trigger logic signal, and then enters the non-trigger periodic cycle-detection and calculation stage, in this stage, it determines whether the finger has entered the effective hover trigger area or not, if not, the acousto-optic feedback control circuit outputs a non-trigger state, and continuing to perform detection and calculation in cycle, until it detects and calculates that the finger has entered the effective hover trigger area, the acousto-optic feedback control circuit outputs a pre-trigger state, at the same time, the hover timer starts timing, and the pre-trigger cycle-detection and calculation stage has be entered. In the pre-trigger cycle-detection and calculation stage, if the finger leaves the effective hover trigger area, the hover timer is cleared, the acousto-optic feedback control circuit outputs a non-trigger state, and it returns to the non-trigger cycle-detection and calculation stage; When the finger further enters the quick trigger area or the hover timer exceeds the pre-determined hover time, the acousto-optic feedback control circuit outputs the trigger state, at the same time, the logic trigger signal is output, and the post-trigger cycle-detection and calculation stage has been entered. In the post-trigger cycle-detection and calculation stage, if the finger leaves the effective hover trigger area, the non-trigger state signal is output, the hover timer is cleared, at the same time, the sound and light feedback non-trigger state, and the non-trigger cycle-detection and calculation stage is returned. The hover button operation method of the present invention can meet the requirements of the following three operation modes: the first is a single-shot trigger mode, that is, the finger can leave the effective hover trigger area immediately after triggering, and does not need to be triggered again (applicable to elevators, various door switches, toilet flush switches etc.); The second is the continuous trigger mode, that is, the finger can leave the effective hover trigger area immediately after triggering, meanwhile it continues to output the trigger logic signal, until the finger triggers the hover switch for the second time, the non-trigger signal will be output (applicable to bath or wash basin faucet switch, various lighting lamp on and off control); The third is the hover-maintaining trigger mode, that is, the finger remains in the effective hover trigger area after triggering, and the trigger logic signal is continuously output during the period, until the finger leaves the effective hover trigger area, the non-trigger logic signal is output (applicable to public water drinking control buttons in offices, high-speed railways, airports, stations etc.).

In view of the fact that the capacitive sensor is susceptible to interference and the measurement sensitivity issue of human fingers under restrictions of the environmental condition of using occasions, it is necessary to make full use of the current mature capacitance-to-digital conversion circuit CDC technology, and then to cooperate with the design of the capacitive sensor to achieve the purpose of the invention.

**Embodiments**

For the case where the elevator button is one, that is, the call button on the lowest floor and the highest floor, Figure 7 shows a most reasonable embodiment, which can also be conveniently applied to other similar fields, such as the design of the trigger button of the faucet; For the scheme of two buttons (double buttons basic control unit) of the elevator up and down switches design, Figure 8 shows an embodiment of a reasonable arrangement; For more floor buttons in the elevator car, considering the interface capability of each CDC chip, the circuit board design to ensure the reliability and accuracy of measurement, as well as economical considerations, the optimal design is to bring a row of buttons together into a set, and each set of a row of buttons is connected to another set by a serial interface like building blocks, and then connected to a master controller. The following three embodiments will be introduced respectively:

**First embodiment**

An embodiment of the hover button of the present invention is an independent hover button, as shown in the structure diagram of the independent hover button in Figure 7 and the circuit principle block diagram in Figure 9, it is made of multiple layers of circuit boards 1-6, the central electrodes 1-1 are made on the top layer of the circuit board, the peripheral electrodes 1-2 are made on the second layer of the circuit board, the active shielding electrodes 1-7 are made on the third layer of the circuit board, and the power supply circuit 5-1, the communication circuit 5-2, CDC circuit 3 and the acousto-optic feedback control circuit 5-3 are arranged on the fourth layer of the circuit board. There are LED light-emitting elements 5-4 on the first layer of the circuit board, the panel 4-1 is made of acrylic or transparent PC, the top layer is screen-printed with luminous ink for the button shape, and other positions on the top layer are screen-printed with opaque ink to ensure it will display the status of button when the LED light-emitting element 5- 4 is lit. The rear side of the panel 4-1 and the top layer of the multi-layer circuit board of the button are connected by bonding, and the metal casing 4-7 can also connect the multi-layer circuit board and the panel by bonding. As shown in the equivalent circuit diagram of Figure 9, on the bottom layer of the multi-layer circuit boards 1-6, there is a special CDC chip 3 integrating CDC and MCU, which is used to measure the capacitance values C1, C2 and C3 of the hover button, and to implement the function of the hover button by calculating the ratio of C1/C2 and comparing the size of C3. Multi-color LED light-emitting element 5-4 is arranged on the top layer of the multi-layer circuit board 1-6 and the acousto-optic feedback control circuit 5-3 is arranged on the bottom layer of the multi-layer circuit board to implement the aforementioned three-state light feedback (that is, when the finger does not enter the effective hover trigger space, the green light is on, when the finger enters the effective hover trigger space, the purple light is on, and after the hover button is triggered, the red light is on), the central electrode 1-1 is arranged on the top layer of the multi-layer circuit board, the peripheral electrodes 1-2 is arranged on the second layer and the active shielding electrodes 1-7 is arranged on the third layer, so as to avoid the problem that the metal casing ground 4-7 and the bottom control circuit layer reduce the sensitivity at the same time. Power supply circuit 5-1, CDC circuit 3 and communication circuit 5-2 are arranged on the fourth layer of the circuit board, to implement the elevator's outbound call control and light indication functions by communicating with the elevator's control and signal system through the serial communication interface. The hover independent button of convex structure of present invention is simple in structure and low in cost, which can be conveniently used to replace the existing mechanical contact independent button switch.

**Second embodiment**

Another embodiment of the hover button of the present invention is double hover buttons used for elevator outbound calls, as shown in the structural diagram 8 and the principle block diagram 9, the central electrodes 1-1 of the two hover buttons are screen-printed with silver paste on the transparent panel 4-1, and under the transparent panel 4-1, a uniform light plate 4-2 for making the beams of light feedback uniform is arranged, the transparent panel and the uniform light plate are fixed with the peripheral electrode PCB board 4-4 by frame 4-3, the vertical distance difference Δd between the central electrode and the peripheral electrode of the convex electrode structure is controlled to be 0.5CM through the frame, and a control PCB board 4-6 is arranged under the electrode PCB board 4-4, as shown in the equivalent circuit diagram of Figure 9, there is the CDC special chip integrating CDC and MCU on the control PCB board 4-6, which is used to measure the capacitance values C1, C2 and C3 of the hover button, and implement the functions of the hover button by calculating the ratio of C1/C2 and comparing the size of C3. Multi-color LED indicator 5-4 and acousto-optic feedback control circuit 5-3 are also arranged on the control PCB board 4-6, which are used to implement the aforementioned three-state light feedback (that is, when the finger does not enter the effective hover trigger space, the green light is on, when the finger enters the effective hover trigger space, the purple light is on, and after the hover button is triggered, the red light is on), the peripheral electrode 1-2, annular active shielding electrodes 1-3 and annular grounded electrode 1-4 are arranged on top of the PCB board 4-4, the active shielding electrodes 1-7 are arranged under the PCB board 4-4, and the active shielding electrodes are connected to the annular active shielding electrodes on the electrode PCB board 4-4 through the PCB vias 1-8, so as to avoid the problem that the metal casing ground and the external annular grounded electrode reduce the sensitivity at the same time. The power supply circuit 5-1, the CDC circuit 3 and the communication feedback circuit 5-2 are also arranged on the control PCB board 4-6, to implement the elevator's outbound call control and light indication functions by communicating with the elevator's control and signal system through the serial communication interface.

**Third embodiment**

Another embodiment of the hover button of the present invention is multi-row hover button used for floor selection control in the elevator car, as shown in the structural diagram 10 and the principle block diagram 9, a plurality of double buttons basic control units 4 and one centralized controller 6 are arranged on metal frame and connected in series through 6-1 independent unit communication lines to connect to the centralized controller 6. Figure 8 of the structural reference diagram of the double buttons basic control unit 4, the central electrodes 1-1 of the double hover buttons are screen-printed on the transparent panel 4-1 with silver paste, the uniform light plate 4-2 for making the beams of light feedback uniform is arranged under the transparent panel 4-1, and the transparent panel and the uniform light plate are fixed with the electrode PCB board 4-4 through the frame 4-3, the vertical distance difference $\Delta d$ between the central electrode and the peripheral electrode of the convex electrode structure is controlled to be 0.5CM through the frame, the control PCB board 4-6 is arranged under the electrode PCB board 4-4, as shown in the equivalent circuit diagram of Figure 9, there is the CDC special chip integrating CDC and MCU on the control PCB board 4-6, which is used to measure the capacitance values C1, C2 and C3 of the hover button, and implement the functions of the hover button by calculating the ratio of C1/C2 and comparing the size of C3. The multi-color LED indicator 5-4 and the acousto-optic feedback control circuit 5-3 are also arranged on the control PCB board 4-6, which are used to implement the aforementioned three-state light feedback (that is, when the finger does not enter the effective hover trigger space, the green light is on, when the finger enters the effective hover trigger space, the purple light is on, and after the hover button is triggered, the red light is on), the peripheral electrode 1-2, annular active shielding electrodes 1-3 and annular grounded electrode 1-4 are arranged on top of the PCB board 4-4, the active shielding electrodes 1-7 are arranged under the PCB board 4-4, and the active shielding electrodes are connected with the annular active shielding electrodes on the electrode PCB board 4-4 through the PCB vias 1-8, so as to avoid the problem that the metal casing ground and the external annular grounded electrode reduce the sensitivity at the same time. The power supply circuit 5-1, the CDC circuit 3 and the communication feedback circuit 5-2 are also arranged on the control PCB board 4-6, the control PCB board 4-6 is connected to the centralized control PCB board 6 through internal serial communication cable 6-1, on the centralized controller 6, there is a MCU (reference No. 6-3) responsible for comprehensively analyzing the button actions of the basic unit 4 to further reduce misoperation, and the centralized power supply module 6-2 is responsible for supplying the power to the power supply circuit 5-1 of independent control unit 4, a centralized communication control module 6-4 is responsible for communicating with the central controller of the elevator, and at the same time communicating with each basic control unit 4, so as to implement the functions of floor control and light indication of the elevator.

**The final effect:**

Compared with the technical solution disclosed in US Patent 7,498,822 B2, in order to avoid the capacitance effect between the central electrode and the external electrode, thereby affecting the measurement of the self-capacitance of the central electrode and the external electrode to the human body or conductive objects, it is required to apply equal voltage signal to the central electrode and the external electrode at the same time when measuring the capacitance, so as to form equipotential between the two electrodes, on the one hand, this design increases the complexity of the measurement circuit and leads to an increase in cost, on the other hand, it is hard to use the correcting effect of the parameter of the mutual capacitance formed between the central electrodes and the external electrodes to the effective distance of the hover triggering; While the capacitance-to-digital conversion circuit adopted in the present invention, such as the CDC chip based on the $\Delta$-$\Sigma$ principle, can periodically time-sharing to measure the self-capacitances C1, C2 of the two electrodes and the value of the mutual capacitance C3 between the two electrodes respectively, the three capacitance measurements do not affect each other, the accurate capacitance values of C1, C2 and C3 can be obtained without the equipotential restriction between the two electrodes. There is also a technical problem to be solved by the hover button, which is to avoid the influence on capacitance measurement due to changes of environmental temperature and humidity; The present invention uses the ratio of the central capacitance to the external capacitance as the main determining basis, while the capacitance ratio has nothing to do with the dielectric constant mainly affected by temperature and humidity.

The hover button of the present invention can effectively prevent false triggering caused by a large area of the human body approaching the hover button, for example, when there are many people in the elevator, the arm or back is close to or appressed to the hover button, and when cleaning the palm or fist is close to the hover button etc.. Making full use of the pointing action of stretching out a finger from the palm of the human body, the general length of the finger is significantly different from the entire palm on the effect to the two electrodes designed by the invention, therefore, considering that most people are accustomed to use the index finger to operate the button switch, while the length of the index finger for adults is about 6-8CM, for children is 4-6CM, in order to avoid the remaining 4 fingers from increasing the projected area of the index finger to the external electrode, the diameter (circular) or side length (foursquare) of the external electrode should be controlled within 4CM.

Finally, it should be noted that the above embodiments are only used to illustrate the technical schemes of the present invention, not to limit the protection scope of the present invention, although the invention has be described in detail with reference to preferred embodiments, it is understood that the technical schemes of the present invention may be modified or equivalently replaced without departing from the spirit and scope of the technical schemes in present invention.

**Claims**

1. A hover button sensor unit, comprising: a power supply circuit (5-1), a capacitive sensor, a capacitance-to-digital conversion circuit (3), a control module, an acousto-optic feedback control circuit (5-3) and a communication circuit (5-2);

   Wherein, the capacitive sensor consists of one or more groups of electrodes, each group of electrodes comprises at least one central electrode (1-1), at least one peripheral electrode (1-2) arranged around the central electrode (1-1), the height of the central electrode (1-1) protruding from the peripheral electrode (1-2) is 1.0-8.9mm;
   Wherein, the capacitance-to-digital conversion circuit (3) comprises a capacitance excitation signal circuit, and the capacitance excitation signal circuit generates a high-frequency square wave excitation signal;
   Wherein, the above-mentioned central electrode (1-1) and peripheral electrode (1-2) are all connected to the capacitance-to-digital conversion circuit (3) to detect self-capacitance and mutual capacitance of the group of central electrode (1-1) and peripheral electrode (1-2) after inducting the approaching of human fingers;
   Wherein, the capacitance-to-digital conversion circuit (3) is connected with the control module, and the control module outputs trigger logic signal of the button according to the range of effective hover trigger area above the central electrode (1-1) where the human finger points to and dwell time within this range.

2. The hover button sensor unit according to claim 1, wherein the above mentioned control module is connected with the acousto-optic feedback control circuit (5-3), and the acousto-optic feedback control circuit (5-3) exhibits three states of non-trigger, pre-trigger and triggered.

3. The hover button sensor unit according to claim 1, wherein there are active shielding electrode (1-7) behind the peripheral electrode (1-2).

4. The hover button sensor unit according to claim 1, wherein there is an annular active shielding electrode (1-3) outside the peripheral electrode (1-2).

5. The hover button sensor unit according to claim 3 or 4, wherein the active shielding electrode (1-3) is connected with the central electrode (1-1) andor the peripheral electrode (1-2) through an operational amplifier to form a voltage follower.

6. The hover button sensor unit according to claim 4, wherein there is a surrounding anti-crosstalk electrode (1-4) outside the annular active shielding electrode (1-3).

7. The hover button sensor unit according to claim 1, wherein the effective hover trigger area above the central electrode (1-1) is a cylinder, the cross-sectional shape of which is the projection of the periphery of the central electrode (1-1), and the bottom of which is the distance dmin away from the central electrode (1-1), dmax is the distance from its top to the central electrode (1-1), the above-mentioned dmin is 0.5CM, and the dmax is 4CM.

8. The hover button sensor unit according to claim 1, wherein the central electrode (1-1) is composed of multiple petals.

9. The hover button sensor unit according to claim 1, wherein the peripheral electrode (1-2) is composed of a closed-loop or an open-loop of circular ring, or a semi-circular ring.

10. A method for providing hover button triggering, wherein, based on the sensor unit defined in claims 1-9, detecting and calculating that the human finger enters the effective hover trigger area above a certain central electrode (1-1) through the capacitive sensor, and providing pre-trigger response of the human finger entering the effective hover trigger area through the acousto-optic feedback control circuit (5-3); If the human finger enters quick trigger area that is closer to the central electrode (1-1) than the effective hover trigger area, the trigger logic signal of the button pointed by the human finger is directly output, and at the same time, the acousto-optic feedback control circuit (5-3) responds to the triggered state; otherwise, it continuously detects whether the human finger stays in the effective hover trigger area or not, if stays and stays exceeding the set hover time, output the trigger signal of the button pointed by the human finger and at the same time the acousto-optic feedback control circuit (5-3) responds to the triggered state; if it is detected that the finger has left the effective hover trigger area within the set hover time, the non-trigger state is returned.

11. The method for triggering the hover button according to claim 10, wherein the hover time is between 0.3 and 5 seconds, and the optimal hover time is 0.5-1 second.

12. The method for triggering the hover button according to claim 10, wherein the effective hover trigger area above the central electrode (1-1) is a cylinder, the cross-sectional shape of which is the projection of the periphery of the central electrode (1-1), and the bottom of which is the distance dmin away from the central electrode (1-1), dmax is the distance from its top to the central electrode (1-1), the above-mentioned dmin is 0.5CM, dmax is 4CM.

13. The method for triggering the hover button according to claim 10, wherein the above mentioned control module is connected with the acousto-optic feedback control circuit (5-3), and the acousto-optic feedback control circuit (5-3) exhibits three states of non-trigger, pre-trigger and triggered.

Figure 1

Figure 2-1

Figure 2-2

Figure 2-3

Figure 2-4

Figure 3-1

Figure 3-2

Figure 4-1

Figure 4-2

Figure 4-3

Figure 5

Figure 6

Figure 7

Figure 8

Figure 9

Figure 10

Figure 11-1　　　Figure 11-2　　　Figure 11-3

Figure 11-4　　　Figure 11-5　　　Figure 11-6

Figure 12

Figure 13-1

Figure 13-2

Figure 14-1

Figure 14-2

## INTERNATIONAL SEARCH REPORT

| International application No. |
|---|
| **PCT/CN2020/089182** |

**A.      CLASSIFICATION OF SUBJECT MATTER**

B66B 1/46(2006.01)i;   H03K 17/955(2006.01)i

According to International Patent Classification (IPC) or to both national classification and IPC

**B.      FIELDS SEARCHED**

Minimum documentation searched (classification system followed by classification symbols)

B66B; H03K

Documentation searched other than minimum documentation to the extent that such documents are included in the fields searched

Electronic data base consulted during the international search (name of data base and, where practicable, search terms used)

WPI, EPODOC, CNPAT, CNKI: 隔空, 悬停, 感应, 非接触, 无接触, 按钮, 按键, 电容, 互电容, 自电容; hover, induction, non-contact, contactless, button, key, switch, capacitance, self-capacitance, mutual

**C.      DOCUMENTS CONSIDERED TO BE RELEVANT**

| Category* | Citation of document, with indication, where appropriate, of the relevant passages | Relevant to claim No. |
|---|---|---|
| A | CN 109450426 A (XI'AN ZHONGYING ELECTRONIC CO., LTD.) 08 March 2019 (2019-03-08)<br>      description, paragraphs [0038]-[0077], and figures 1-8 | 1-13 |
| A | CN 107765931 A (ZHUHAI SPACETOUCH TECHNOLOGY CO., LTD.) 06 March 2018 (2018-03-06)<br>      entire document | 1-13 |
| A | CN 101833121 A (SHENZHEN GOODIX TECHNOLOGY CO., LTD.) 15 September 2010 (2010-09-15)<br>      entire document | 1-13 |
| A | CN 104699335 A (ATMEL CORPORATION) 10 June 2015 (2015-06-10)<br>      entire document | 1-13 |
| A | CN 103076939 A (ORISE TECHNOLOGY CO., LTD.) 01 May 2013 (2013-05-01)<br>      entire document | 1-13 |
| A | US 4022296 A (WESTINGHOUSE ELECTRIC CORPORATION) 10 May 1977 (1977-05-10)<br>      entire document | 1-13 |

☐ Further documents are listed in the continuation of Box C.          ☑ See patent family annex.

| | |
|---|---|
| *       Special categories of cited documents:<br>"A"   document defining the general state of the art which is not considered to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
|---|---|
| **31 December 2020** | **12 January 2021** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088**<br>**China** | |
| Facsimile No. **(86-10)62019451** | Telephone No. |

Form PCT/ISA/210 (second sheet) (January 2015)

INTERNATIONAL SEARCH REPORT
Information on patent family members

International application No.

**PCT/CN2020/089182**

| Patent document cited in search report | | | Publication date (day/month/year) | Patent family member(s) | | | Publication date (day/month/year) |
|---|---|---|---|---|---|---|---|
| CN | 109450426 | A | 08 March 2019 | None | | | |
| CN | 107765931 | A | 06 March 2018 | CN | 207281736 | U | 27 April 2018 |
| CN | 101833121 | A | 15 September 2010 | CN | 101833121 | B | 10 August 2011 |
| CN | 104699335 | A | 10 June 2015 | CN | 109976593 | A | 05 July 2019 |
| | | | | CN | 104699335 | B | 29 March 2019 |
| | | | | TW | I633479 | B | 21 August 2018 |
| | | | | TW | 201535220 | A | 16 September 2015 |
| | | | | US | 9128577 | B2 | 08 September 2015 |
| | | | | DE | 102014225254 | A1 | 11 June 2015 |
| | | | | US | 2015160756 | A1 | 11 June 2015 |
| CN | 103076939 | A | 01 May 2013 | CN | 103076939 | B | 09 March 2016 |
| US | 4022296 | A | 10 May 1977 | CA | 1070411 | A | 22 January 1980 |
| | | | | BR | 7602958 | A | 07 June 1977 |
| | | | | FR | 2311366 | A1 | 04 January 1977 |
| | | | | US | 4019607 | A | 26 April 1977 |
| | | | | BE | 841882 | A | 16 November 1976 |
| | | | | CA | 1046418 | A | 16 January 1979 |
| | | | | GB | 1551960 | A | 05 September 1979 |
| | | | | US | 4022296 | A | 10 May 1979 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201480079328
- WO 201610551225 A
- US 7498822 B
- US 5134401 A
- US 7498822 B2